# EUROPÄISCHE PATENTSCHRIFT

(11) **EP 2 456 133 B1**
(45) Veröffentlichungstag und Bekanntmachung des Hinweises auf die Patenterteilung: **16.07.2014**
(21) Anmeldenummer: 10191858.9
(22) Anmeldetag: 19.11.2010
(51) Int. Cl.: H04L 12/931

(54) **Modularer Schalt-Netzknoten für ein Kommunikationsnetzwerk**
Modular switch network nodes for a communication network
Noeud de réseau de commutation modulaire pour un réseau de communication

(43) Veröffentlichungstag der Anmeldung: 23.05.2012
(73) Patentinhaber: Siemens Aktiengesellschaft, 80333 München (DE)
(72) Erfinder: Schweizer, Urs, 76316, Malsch-Waldprechtsweier (DE); Hack, Heiko, 91301, Forchheim (Kersbach) (DE); Kistner, Timo, 76456, Kuppenheim (DE); Schäffler, Andreas, 76131, Karlsruhe (DE); Wagner, Michael, 76764, Rheinzabern (DE)

(56) Entgegenhaltungen:
- WO-A1-03/077088
- US-B1- 7 664 110
- Moxa: "Industrial Ethernet for Control and Automation", , 6. Mai 2010 (2010-05-06), XP002642160, Gefunden im Internet: URL:http://www.moxa.com/support/request_ca talog_detail.aspx?id=141 [gefunden am 2011-06-15]

## Beschreibung

Die vorliegende Erfindung betrifft einen modularen Schalt-Netzknoten für ein Kommunikationsnetzwerk, insbesondere ein industrielles Kommunikationsnetzwerk, wobei der modulare Schalt-Netzknoten eine Schalt-Netzknoten-Basiseinheit und mindestens ein Port-Modul umfasst, und wobei das mindestens eine Port-Modul mindestens eine Anschluss-Schnittstelle zur Ankopplung an ein Kommunikationsnetz aufweist, und der modulare Schalt-Netzknoten zur Weiterleitung von über eine Anschlussschnittstelle des modularen Schalt-Netzknotens eingehende Kommunikationsdaten an mindestens eine weitere der Anschluss-Schnittstellen des modularen Schalt-Netzknotens ausgebildet und eingerichtet ist.

Derartige Schalt-Netzknoten sind aus dem Stand der Technik bekannt. So offenbart beispielsweise das US-Patent US 7,085,875 B1 einen modularen Switch für ein Ethernet und/oder ein ATM-Netz mit Einschubkarten, die jeweils Ports für solche Netze umfassen beziehungsweise an entsprechende Ports wiederum anschließbar oder angeschlossen sind. Es ist ein Nachteil des Standes der Technik, dass sich auf diese Weise zwar die Anzahl und und/oder der Art von Kommunikations-Schnittstellen verändern lässt, allerdings ist ein solcher Switch nicht flexibel an neue Anwendungen oder Kommunikationsprotokolle anpassbar, da die grundlegenden Eigenschaften des Switches auch beim Wechsel eines Portmoduls unverändert bleiben.

US7664110 beschreibt eine Switch-Architektur mit austauschbaren Modulen.

Daher ist es eine Aufgabe der vorliegenden Erfindung, einen Schalt-Netzknoten für ein Kommunikations-Netzwerk, insbesondere ein industrielles Kommunikations-Netzwerk, zur Verfügung zu stellen, welches flexibler an geänderte oder neue Anforderungen anpassbar ist.

Die vorliegende Aufgabe wird gelöst durch einen modularen Schalt-Netzknoten mit den Merkmalen des vorliegenden Patentanspruchs 1.

Ein solcher modularer Schalt-Netzknoten ist zur Weiterleitung von Kommunikationsdaten innerhalb eines Kommunikations-Netzwerks oder zwischen Kommunikations-Netzwerken, insbesondere innerhalb oder zwischen industriellen Kommunikations-Netzwerken, eingerichtet und umfasst eine Schalt-Netzknoten-Basiseinheit und mindestens ein Port-Modul, wobei das mindestens eine Port-Modul mindestens eine Anschluss-Schnittstelle zur Ankopplung an das Kommunikations-Netz aufweist, und
- wobei der modular Schalt-Netzknoten zur Weiterleitung von über eine der Anschluss-Schnittstellen des modularen Schalt-Netzknotens eingehende Kommunikationsdaten an mindestens eine weitere der Anschluss-Schnittstellen des modularen Schalt-Netzknotens ausgebildet und eingerichtet ist,
- und wobei weiterhin die Schalt-Netzknoten-Basiseinheit derart ausgebildet und eingerichtet ist, dass mindestens eines des mindestens einen Port-Moduls gegen ein Funktionsmodul zur Erweiterung der Funktionalität des Schalt-Netzknotens austauschbar ist. Zusätzlich kann das Port-Modul weiterhin auch gegen ein alternatives Port-Modul austauschbar sein.

Dabei kann das alternative Port-Modul beispielsweise gleichartig zum Port-Modul sein, um beispielsweise ein defektes Port-Modul zu ersetzen oder beispielsweise auch eine andere Art, Anzahl und/oder Kombination davon von Anschluss-Schnittstellen aufweisen, um so die Kommunikations-Fähigkeit des modularen Schalt-Netzknotens zu verändern und an aktuelle Gegebenheiten anpassen zu können.

Durch die Möglichkeit, anstatt eines Port-Moduls ein Funktions-Modul zur Erweiterung der Funktionalität des Schalt-Netzknotens einzusetzen, ergibt sich die Möglichkeit, den modularen Schalt-Netzknoten an neue Anforderungen, Protokolle, Anwendungen, Funktionalitäten oder Ähnliches anzupassen. Dadurch, dass das Funktionsmodul ein Port-Modul ersetzen kann, zieht eine solche Erweiterung auch keine bauliche Vergrößerung des modularen Schalt-Netzknotens nach sich beziehungsweise, es müssen deshalb nicht von vornherein Leerräume im Schalt-Netzknoten eingeplant werden, um möglicherweise später die Funktionalität erweitern zu können. Damit ist es beispielsweise möglich, dass ein bereits in eine Anlage eingebauter modularer Schalt-Netzknoten so unverändert dort verbleiben kann bzw. an derselben Stelle wieder einsetzbar ist.

Ein Schalt-Netzknoten kann beispielsweise als so genannter "Switch", als eine so genannter "Bridge", als so genannter "Hub", als so genannter "Router" oder ein ähnlicher Schalt-Netzknoten zur Weiterleitung und Verteilung von Kommunikations-Daten innerhalb eines Kommunikations-Netzwerks oder zwischen Kommunikations-Netzen oder Kommunikations-Teilnetzen ausgebildet und eingerichtet sein. Dabei können solche Kommunikations-Netze insbesondere industrielle Kommunikations-Netze ausgebildet sein.

Kommunikations-Netzwerke können dabei beispielsweise ein Ethernet, ein ATM-Netz, eine Telekommunikations-Netzwerk, ein Drahtlos-Netzwerk, das Internet oder andere vergleichbare Telekommunikations-Netzwerke sein.

Ein industrielles Kommunikations-Netzwerk kann beispielsweise als ein industrielles Ethernet (z.B. Industrial Ethernet), ein PROFINET, ein "industrial WLAN"-Netz oder ein anderes Industrie-Kommunikations-Netz oder ein Feldbuss ausgebildet sein.

Anschluss-Schnittstellen können beispielsweise entsprechende Stecker oder Buchsen, z.B. zum Anschluss entsprechender Kommunikations-Leitungen, sein, z.B. ein RJ45-Ethernet-Stecker zum Anschluss einer Ethernet-Leitung. Weiterhin können solche Anschluss-Schnittstellen auch zum Anschluss einer WLAN-Antenne oder vergleichbaren Antenne für ein Drahtlos-Netzwerk ausgebildet sein. Eine Anschluss-Schnittstelle kann auch als ein aus einem Port-Modul oder dem Schalt-Netzknoten herausgeführte Leitung zum Anschluss an weitere Leitungen oder ein anderes Gerät oder beispielsweise auch eine Antenne für ein WLAN-Netz oder Telekommunikations-Netz sein.

Dass der modulare Schalt-Netzknoten zur Weiterleitung von Kommunikations-Daten ausgebildet ist, kann beispielsweise bedeuten, dass der Schalt-Netzknoten beispielsweise eine Switching-Funktionalität eines so genannten Ethernet-Switchs oder vergleichbarer "Switche" für die oben genannten Kommunikations-Netzwerke aufweist beziehungsweise Teile oder wesentliche Teile einer solchen Funktionalität aufweist. Weiterhin kann die Weiterleitung auch eine Routing-Funktionalität bedeuten oder umfassen. Insbesondere kann im Rahmen einer solchen Weiterleitungs-Funktionalität vorgesehen sein, dass eine bestimmte Nachricht, die über einen der Anschluss-Schnittstellen eingeht, beispielsweise nicht weitergeleitet wird. Dies kann z.B. in dem Fall auftreten in welchem der Empfänger der Nachricht bereits in dem Zweig des Kommunikations-Netzes sitzt, aus welchem die Nachricht zum Schalt-Netzknoten kam, wenn die Adresse der Nachricht gesperrt ist oder in welcher ein anderes Kriterium erfüllt ist. Weiterhin kann vorgesehen sein, dass eine bestimmte Nachricht an mehrere Anschluss-Schnittstellen ausgegeben wird, wenn beispielsweise der Empfänger im Schalt-Netzknoten unbekannt ist oder es sich z.B. um eine Broadcast- oder Multicast-Nachricht handelt.

Ein Port-Modul kann dabei ein oder mehrere Anschluss-Schnittstellen aufweisen. Weiterhin kann ein Port-Modul auch Anschluss-Schnittstellen aufweisen, die sich in den zur Verfügung gestellten Datenraten oder verarbeitbaren Datenraten unterscheiden und/oder andern Kommunikations-Protokollen oder Kommunikations-Standards entsprechen.

Der modulare Schalt-Netzknoten kann auch weitere Anschluss-Schnittstellen aufweisen, die nicht Teil des oder eines Port-Moduls sind, sondern fest am modularen Schalt-Netzknoten vorgesehen sind.

Die Erweiterung der Funktionalität des Schalt-Netzknotens kann beispielsweise das Hinzufügen einer neuen Funktionalität sein, wobei diese neue Funktionalität über das reine Hinzufügen beziehungsweise Ändern von Kommunikations-Schnittstellen (andere Kommunikations-Protokolle und/oder Datenraten) hinausgeht. Die Erweiterung der Funktionalität kann beispielsweise ein Hinzufügen einer Funktionalität auf der OSI-Schicht "layer 4" oder höher sein. Insbesondere kann die Erweiterung der Funktionalität das Hinzufügen einer Funktionalität auf layer 4 bis layer 7 im OSI-Schichtmodell bedeuten.

Die Schalt-Netzknoten-Basiseinheit sowie das Port-Modul und das Funktions-Modul können beispielsweise so ausgebildet und eingerichtet sein, dass das Port-Modul gegen das Funktions-Modul einfach austauschbar ist, insbesondere durch einen Bediener einfach austauschbar ist. Das bedeutet, dass z.B. ein Bediener beispielsweise das Port-Modul mit einem oder wenigen Handgriffen von der Schalt-Netzknotenbasiseinheit entfernen und stattdessen ebenfalls mit einem oder wenigen Handgriffen das Funktionsmodul an diesen Platz setzen kann.

Dabei kann die einfache Austauschbarkeit beispielsweise dadurch gegeben sein, dass die jeweiligen Module in der Basiseinheit allein durch die Haltekräfte von verbundenen Steckverbindungen sowie gegebenenfalls einer Lastaufnahme durch Gehäuse von Modul und/oder Basiseinheit gehalten werden. Weiterhin kann auch vorgesehen sein, dass eine zusätzliche Arretierung oder Sicherung des Portmoduls oder des Funktionsmoduls gegen ein Herausfallen oder eine unabsichtliche Entnahme des Moduls vorgesehen ist, beispielsweise durch einen Verriegelungsmechanismus, eine Verschraubung, eine Verrastung oder Ähnliches. Auch in diesem Fall kann aber das jeweilige Modul in wenigen Handgriffen, beispielsweise durch Lösen der Verschraubung oder der Verriegelung oder Verrastung einfach entnehmbar beziehungsweise in die Basiseinheit einbringbar sein.

Die genannte Aufgabe wird ebenfalls gelöst von einer Schalt-Netzknoten-Basiseinheit gemäß der vorliegenden Beschreibung für einen Schalt-Netzknoten gemäß der vorliegenden Beschreibung.

Dabei kann die Schalt-Netzknoten-Basiseinheit einen oder mehrere zur Aufnahme von je einem Port-Modul oder einem Funktionsmodul vorgesehene und eingerichtete Modul-Aufnahmebereich aufweisen.

Auf diese Weise lässt sich die Anpassung des Schalt-Netzknotens an verschiedene Anwendungen weiterhin vereinfachen, da durch die Aufnahmebereiche eine einfache Austauschbarkeit von Modulen und somit eine vereinfachte Anpassung durch Einbau eines Funktionsmoduls, beispielsweise anstatt eines Port-Moduls erreichen.

Modul-Aufnahmebereiche können beispielsweise als zur Aufnahme eines Moduls vorgesehene Leerräume mit entsprechenden Steckplätzen für Anschluss-Schnittstellen des Moduls an die Schalt-Netzknoten-Basiseinheit sein. Solche Leerräume können beispielsweise als Modulschächte und/oder Modul-Steckplätze ausgebildet sein. Dabei kann ein solcher Modul-Aufnahmebereich weiterhin beispielsweise so ausgestaltet sein, dass das Modul gegen unabsichtliches Entfernen, beispielsweise Herausfallen oder unabsichtliches Entnehmen, gesichert ist. Wie vorstehend ausgeführt, kann dies beispielsweise allein durch entsprechende Steckerkräfte und/oder Lastaufnahme durch die Ausgestaltung der Schalt-Netzknoten-Basiseinheit sowie des Moduls erreicht werden. Weiterhin kann auch eine Arretierung zur Sicherung eines Moduls in der Basiseinheit, beispielsweise durch Verschraubung, Verrastung oder Ähnliches, vorgesehen sein.

In einer vorteilhaften Ausgestaltung weist die Schalt-Netzknoten-Basiseinheit einen internen Netzwerkbus zur Weiterleitung von über eine Anschluss-Schnittstelle empfangenen Kommunikations-Daten innerhalb der Schalt-Netzknoten-Basiseinheit und einen Systembus auf, wobei der Systembus insbesondere zur Kommunikation mit einer zentralen Steuereinheit des Schalt-Netzknotens ausgebildet und eingerichtet ist,
- wobei weiterhin die Schalt-Netzknoten-Basiseinheit im Bereich mindestens eines Modul-Aufnahmebereichs eine Netzwerkbus-Schnittstelle zur Kontaktierung eines in dem Modul-Aufnahmebereich befindlichen Port-Moduls und eine Systembus-Schnittstelle zur Kontaktierung eines in den Modul-Aufnahmebereich befindlichen Funktionsmoduls aufweist.

Auf diese Weise ist ein Modul-Aufnahmebereich, beispielsweise ein Modulschacht, bereits baulich sowohl zur korrekten Bearbeitung eines Port-Moduls als auch zur korrekten Bearbeitung eines Funktions-Moduls ausgerüstet. Auf diese Weise ist unabhängig davon, welche Funktionalität das Funktions-Modul genau dem Schalt-Netzknoten hinzufügt, dafür gesorgt, dass das Funktions-Modul auch Zugriff auf den Systembus und somit die zentrale Steuereinheit des Schalt-Netzknotens hat und/oder umgekehrt. Damit lässt sich die Funktionalität des Schalt-Netzknotens flexibel erweitern, da für ein Funktionsmodul beispielsweise sowohl die Daten auf dem Netzwerkbus als auch Informationen und Einstellungen, die von der zentralen Steuereinheit gehandhabt werden, zur Verfügung hat.

Ein interner Netzwerkbus kann beispielsweise ein so genannter "interner High-Speed-Netzwerkbus" oder ähnliche interne Kommunikationsbusse sein. Ein Systembus kann beispielsweise ein interner Kommunikationsbus, beispielsweise zur Kommunikation zwischen verschiedenen Komponenten eines Computerrechners oder Schalt-Netzknoten sein. Ein solcher Bus kann beispielsweise als so genannter "PCI", "PCI-Express" (PCIe) oder als vergleichbarer interner Systembus ausgebildet sein.

Die zentrale Steuereinheit des Schalt-Netzknotens kann beispielsweise als CPU, als Mikroprozessor oder auch als ein so genanntes "Motherboard" oder eine ähnliche zentrale Steuereinheit ausgebildet und eingerichtet sein. Dabei kann die zentrale Steuereinheit beispielsweise ein Teil der Schalt-Netzknoten-Basiseinheit sein. Weiterhin kann die zentrale Steuereinheit beispielsweise auch ganz oder teilweise Teil eines Funktionsmoduls sein.

Dabei kann beispielsweise weiterhin vorgesehen sein, dass nur ein Modul-Aufnahmebereich sowohl eine Netzwerkbus-Schnittstelle als auch eine Systembus-Schnittstelle aufweist und so zur Austauschbarkeit zwischen Port-Modulen und Funktions-Modulen ausgebildet ist. Weiterhin können auch mehrere der Modul-Aufnahmebereiche einer Schalt-Netzknoten-Basiseinheit oder auch alle Modul-Aufnahmebereiche der Schalt-Netzknoten-Basiseinheit so ausgebildet sein.

Netzwerkbus-Schnittstellen und/oder Systembus-Schnittstellen können beispielsweise als entsprechende Stecker, Buchsen oder Kontaktelemente ausgebildet sein oder solche umfassen. Solche Stecker oder Buchsen können beispielsweise als Steckerleisten oder Ähnliches ausgebildet sein, wie sie für derartige Bus-Schnittstellen regelmäßig verwendet werden.

Unter einem "in einem Modul-Aufnahmebereich befindlichen Port-Modul" oder "in einem Modul-Aufnahmebereich befindlichen Funktions-Modul" wird im Rahmen der vorliegenden Beschreibung verstanden, dass das jeweilige Modul am dafür vorgesehenen Platz und in Kontakt mit den für das Modul vorgesehenen Schnittstellen der Basiseinheit ist.

Ein im Modul-Aufnahmebereich befindliches Funktionsmodul kann dabei zusätzlich zur Kontaktierung mit dem Systembus über seine Systembus-Schnittstelle auch noch eine Netzwerkbus-Schnittstelle aufweisen, mit der das Funktionsmodul im Modul-Aufnahmebereich mit dem internen Netzwerk-Bus verbunden ist.

Das Funktions-Modul kann beispielsweise als reines Funktions-Modul ausgebildet sein, welches ausschließlich eine zusätzliche Funktionalität zum Schalt-Netzknoten hinzufügt. Weiterhin kann das Funktions-Modul auch als kombiniertes Funktions- und Port-Modul ausgebildet sein, welches sowohl Kommunikationsaufgaben übernimmt, als auch dem Schalt-Netzknoten eine zusätzliche Funktionalität hinzufügt.

Weiterhin kann ein Port-Modul und/oder ein Funktions-Modul eine Stromversorgungs-Schnittstelle aufweisen, welche zur Kontaktierung einer Stromquelle beziehungsweise eines Netzteils in der Schalt-Netzknoten-Basiseinheit ausgebildet und eingerichtet ist, wenn sich das Modul in einem Modul-Aufnahmebereich der Basiseinheit befindet.

Die Schalt-Netzknoten-Basiseinheit kann weiterhin zur Erkennung und/oder Konfiguration eines in einem ihrer Modul-Aufnahmebereiche befindlichen Funktions-Modul ausgebildet und eingerichtet sein. Insbesondere kann die Schalt-Netzknoten-Basiseinheit zur Konfiguration und/oder Diagnose eines in einem ihrer Modul-Aufnahmebereiche befindlichen Funktions-Moduls über eine Benutzer-Schnittstelle des Schalt-Netzknotens ausgebildet und eingerichtet sein.

Damit ergibt sich weiterhin eine vereinfachte Anpassbarkeit des Schalt-Netzknotens an geänderte Anforderungen. Dadurch, dass die Basiseinheit ein Funktions-Modul, z.B. selbsttätig, erkennen kann und sich somit gegebenenfalls entsprechend daran anpassen kann, wird die Integration der neuen Funktionalität in den Schalt-Netzknoten vereinfacht. Dabei kann, wie vorstehend erläutert, die Erkennung und/oder Konfiguration eines neu in einen Modul-Aufnahmebereich eingebrachten Funktions-Moduls beispielsweise selbsttätig durch die Schalt-Netzknoten-Basiseinheit erfolgen oder auch beispielsweise nach einem Auslöse-Schritt durch einen Benutzer durch die Schalt-Netzknoten-Basiseinheit erfolgen.

Weiterhin kann vorgesehen sein, dass die Konfiguration und/oder die Diagnose eines in der Basiseinheit befindlichen Funktions-Moduls über eine Benutzer-Schnittstelle des Schalt-Netzknotens erfolgen kann. So kann beispielsweise ein entsprechendes Funktions-Modul und gegebenenfalls dessen Eigenschaften auf einem Benutzer-Interface für den Schalt-Netzknoten, beispielsweise einer Web-Page, einer Software-Benutzeroberfläche oder einer sonstigen Bedieneinheit für den Schalt-Netzknoten angezeigt werden und gegebenenfalls dadurch auch Eigenschaften und Parameter des Funktions-Moduls eingestellt werden.

Die vorstehend genannte Aufgabe wird auch gelöst durch ein Funktions-Modul gemäß der vorliegenden Beschreibung für eine Schalt-Netzknoten-Basiseinheit gemäß der vorliegenden Beschreibung.

Dabei kann das Funktions-Modul beispielsweise eine Modul-Systembus-Schnittstelle aufweisen, welche zur Kommunikation mit der Systembus-Schnittstelle eines Modul-Aufnahmebereichs einer Schalt-Netzknoten-Basiseinheit gemäß der vorliegenden Beschreibung ausgebildet sein. Die Modul-System-Schnittstelle ist dabei zur Kommunikation mit der Systembus-Schnittstelle bei im Modul-Aufnahmebereich befindlichem Funktions-Modul ausgebildet.

Eine solche Modul-Systembus-Schnittstelle kann beispielsweise als entsprechender Stecker, Buchse oder Kontaktelement zur Wechselwirkung mit einer Systembus-Schnittstelle der Basiseinheit ausgebildet sein. Weiterhin kann das Funktionsmodul auch noch eine Modul-Netzwerk-Schnittstelle zur Kommunikation mit der Netzwerk-Schnittstelle eines Modul-Aufnahmebereichs einer Schalt-Netzknoten-Basiseinheit gemäß der vorliegenden Beschreibung aufweisen, sowie eine Modul-Stromversorgungs-Schnittstelle zur Stromversorgung des Funktions-Moduls durch die Schalt-Netzknoten-Basiseinheit.

Das Funktions-Modul kann dabei so ausgebildet sein, dass außer der Modul-Systembus-Schnittstelle und einer Stromversorgungs-Schnittstelle keine weiteren Schnittstellen zur Schalt-Netzknoten-Basiseinheit vorgesehen sind. Weiterhin kann vorgesehen sein, dass ein Funktions-Modul keine Anschluss-Schnittstellen gemäß der vorliegenden Beschreibung zur Ankopplung an Kommunikations-Netze beziehungsweise industrielle Kommunikations-Netze gemäß der vorliegenden Beschreibung aufweist. In diesem Fall kann das Funktions-Modul als reines Funktions-Modul ausgebildet sein, welches ausschließlich eine Funktionalität zum Schalt-Netzknoten hinzufügt und keine weiteren Kommunikationsaufgaben übernimmt und auch in keine solchen involviert ist.

Weiterhin kann ein Funktions-Modul aber auch als externe Anschluss-Schnittstellen für Kommunikations-Netze gemäß der vorliegenden Beschreibung umfassen und auch Kommunikationsaufgaben übernehmen oder beeinflussen.

Das Funktions-Modul kann auch weiterhin derart ausgebildet sein, dass es Anschluss-Schnittstellen gemäß der vorliegenden Beschreibung zur Ankopplung an ein oder mehrere Kommunikations-Netze aufweist, wobei die Verarbeitung der über solche Anschluss-Schnittstellen ankommenden Kommunikations-Daten ausschließlich im Funktions-Modul erfolgt und keine Weiterleitung an den internen Netzwerk-Bus erfolgt.

Über die Modul-Systembus-Schnittstelle kann das Funktions-Modul zur Kommunikation mit der zentralen Steuereinheit des Schalt-Netzknotens ausgebildet und eingerichtet sein. Auf diese Weise kann beispielsweise ein Funktionsmodul mit einer CPU, einem Motherboard oder einer anderen zentralen Steuereinrichtung des Schalt-Netzknotens kommunizieren, um beispielsweise entsprechende Regelungsmechanismen oder Konfigurationen einzustellen oder zu verändern beziehungsweise Informationen von dort abzufragen.

In einer vorteilhaften Ausgestaltung kann das Funktions-Modul beispielsweise als zusätzliche Recheneinheit oder Zentraleinheit, insbesondere zur Unterstützung einer zentralen Steuereinheit des Schalt-Netzknotens ausgebildet sein beziehungsweise eine solche Recheneinheit oder Zentraleinheit umfassen. Auf diese Weise lässt sich beispielsweise die Rechenleistung oder Leistungsfähigkeit des Schalt-Netzknotens weiter erhöhen und so gegebenenfalls an geänderte Leistungsanforderungen anpassen. Über eine Kopplung eines solchen Funktions-Moduls über den Systembus an die Zentraleinheit des Schalt-Netzknotens lässt sich dann die anliegende Arbeit auf diese Komponenten verteilen und so die Leistungsfähigkeit des Schalt-Netzknotens erhöhen.

Bei diesem Beispiel für ein Funktions-Modul sowie nachfolgend genannten Beispielen für Funktions-Module kann beispielsweise vorteilhafter Weise ein so genannter PCI-express (PCIe)-Bus als Systembus eingesetzt werden, da dieser generell gut zur internen Kommunikation zwischen der Zentraleinheit einer Datenverarbeitungseinrichtung und entsprechenden funktional erweiternden Zusatz-Modulen und Steckkarten eingerichtet und ausgebildet ist.

Weiterhin kann ein Funktions-Modul beispielsweise auch als ein Server-Modul zur Realisierung einer Server-Funktionalität mit einer selbständigen Zentraleinheit ausgebildet sein oder eine solche Funktionalität beziehungsweise ein solches Server-Modul umfassen. Auf diese Weise kann beispielsweise ein Zusatz-Modul zur Realisierung eines Radius-Servers, eines DHCP-Servers, von Monitoring-Funktionen oder auch vergleichbaren Server-Funktionalitäten realisiert werden.

Ein Funktions-Modul kann auch als Anzeige-Modul und/oder Bedien-Modul für den Schalt-Netzknoten ausgebildet sein. Ein solches Funktions-Modul kann beispielsweise ein Display und/oder Eingabeelemente zur Eingabe von Informationen, wie beispielsweise Schalter, Knöpfe oder auch einen Touch-Screen umfassen. Dabei können über das Anzeige-Modul beispielsweise Kommunikationsdaten einzelner oder mehrerer Ports des Schalt-Netzknotens, Diagnosedaten, Zustandsdaten oder Ähnliches von einzelnen oder beziehungsweise mehreren Ports des Schaltnetz-Knotens ausgebildet sein. Das Anzeige-Modul kann beispielsweise als Bildschirm beispielsweise zur Darstellung von Text oder Bildern ausgebildet sein. Über ein solches Anzeige- und/oder Bedien-Modul können beispielsweise auch Daten für den Schalt-Netzknoten eingegeben werden und dieser beispielsweise auch konfiguriert werden. Auch die Konfiguration und Einstellung einzelner oder mehrerer der Ports des Schalt-Netzknotens kann so erfolgen.

Weiterhin kann das Funktions-Modul auch beispielsweise als ein Energiespar-Modul zur Einrichtung und/oder dem Betrieb von Energiespar-Funktionalitäten des Schalt-Netzknotens oder als Energiespar-Modul für den Schalt-Netzknoten ausgebildet sein. Solche Energiespar-Funktionalitäten können beispielsweise die Einstellung, Einrichtung und den Betrieb verschiedener so genannter "Power-Save-Zustände" des Schalt-Netzknotens oder einzelner oder mehrerer Ports des Schalt-Netzknotens umfassen. Weiterhin kann beispielsweise durch ein solches Energiespar-Modul auch eine Schlaf-Funktion und entsprechend eine "Wake-Up-Funktion" für den Schalt-Netzknoten implementiert oder verbessert werden.

Das Funktions-Modul kann auch als Kommunikations-Sicherheits-Modul mit einer Funktionalität zur Einrichtung und/oder Erhöhung von Sicherheits-Funktionen bei der Kommunikation über mindestens eine der Anschluss-Schnittstellen des Schalt-Netzknotens ausgebildet sein. Dabei kann ein solches Kommunikations-Sicherheits-Modul, beispielsweise eigene externe Anschluss-Schnittstellen aufweisen und die Sicherheit der Kommunikation über diese Schnittstellen kontrollieren beziehungsweise erhöhen. Weiterhin kann ein solches Kommunikations-Sicherheits-Modul auch die Kommunikation über andere, nicht an diesem Funktions-Modul befindliche Anschluss-Schnittstellen überwachen, einrichten und/oder erhöhen. Ein Kommunikations-Sicherheits-Modul kann z.B. ausschließlich zur Ausführung eine der beiden vorangehend dargestellten Funktionalitäten eingerichtet sein oder auch beide der genannten Funktionalitäten ausführen können.

Solche Sicherheits-Funktionen können beispielsweise eine Firewall-Funktionalität, eine VPN-Funktionalität, eine Verschlüsselung und/oder Entschlüsselung von Daten oder auch eine Authentifizierungs-Funktionalität sein beziehungsweise umfassen.

Ein Funktions-Modul kann weiterhin auch als Echtzeit-Kommunikations-Modul zur Einrichtung, Erweiterung oder Verbesserung der Echtzeit-Kommunikation beziehungsweise einer Echtzeit-Kommunikationsfähigkeit über mindestens eine der Anschluss-Schnittstellen des Schalt-Netzknotens ausgebildet sein. Dabei kann ein solches Echtzeit-Kommunikations-Modul beispielsweise selbst eine oder mehrere externe Anschluss-Schnittstellen aufweisen und zur Herstellung einer Echtzeit-Kommunikationsfähigkeit dieser Schnittstellen ausgebildet sein. Weiterhin kann ein solches Funktions-Modul auch die Echtzeitfähigkeit beziehungsweise die Fähigkeit zur Echtzeit-Kommunikation über andere, am Schalt-Netzknoten befindliche Anschluss-Schnittstellen betreffen. Dabei kann die Echtzeit-Kommunikation beispielsweise ausschließlich zur Ausführung einer der oben genannten Fälle eingerichtet sein oder auch beide der genannten Fälle durchführen können.

Eine solche Echtzeit-Kommunikation kann beispielsweise zur Herstellung der Echtzeit-Fähigkeit über ein industrielles Ethernet, ein PROFI-Net, ein Real-Time-Ethernet oder eines ähnlichen Netzwerks oder Kommunikationspartners ausgebildet sein.

Ein solches Echtzeit-Kommunikations-Modul kann beispielsweise weiterhin einen Taktgenerator (z.B. einen TCXO) und/oder eine Zeitsynchronisierungseinheit beispielsweise zur Uhrzeitsynchronisation (z.B. gemäß IEEE 1588) oder zur Taktsynchronisation (z.B. gemäß dem SyncE-Standard) oder etwas Ähnliches umfassen.

Ein Funktions-Modul kann weiterhin auch als Synchronisations--Modul beispielsweise zur Taktsynchronisation innerhalb eines Kommunikationsnetzwerks, z.B. gemäß dem SyncE-Standard, oder zur Uhrzeitsynchronisation innerhalb eines Kommunikationsnetzwerks, z.B. gemäß dem IEEE 1588 - Standard, ausgebildet sein. Ein solches Synchronisations-Modul kann weiterhin auch einen Taktgenerator (z.B. einen TCXO) umfassen.

Die vorstehend genannte Aufgabe wird ebenfalls gelöst durch einen Schalt-Netzknoten gemäß der vorliegenden Beschreibung mit einer Schalt-Netzknoten-Basiseinheit gemäß der vorliegenden Beschreibung sowie einem Funktions-Modul gemäß der vorliegenden Beschreibung und/oder einem Port-Modul gemäß der vorliegenden Beschreibung.

Weitere vorteilhafte Ausgestaltungen finden sich in den Unteransprüchen.

Im Folgenden wird die vorliegende Erfindung beispielhaft mit Bezug auf die beiliegende Figur näher erläutert.

Es zeigt:

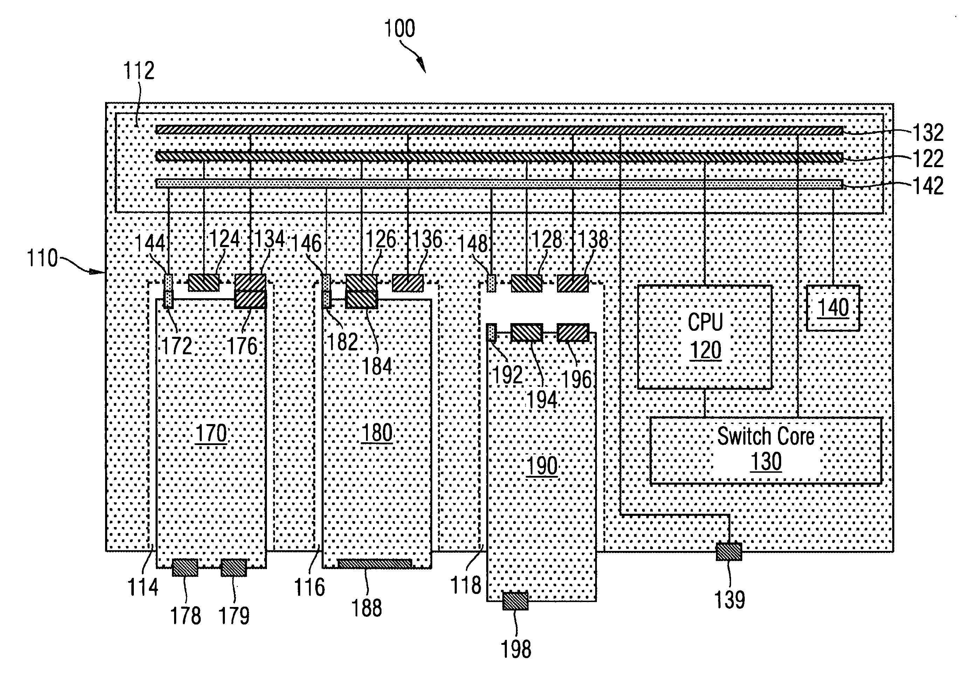

Figur 1: Beispiel für einen "Switch" mit Port- und Funktionsmodulen.

Figur 1 zeigt einen Ethernet-Switch 100, welcher aus einer Basis-Einheit 110, einem darin eingesteckten Port-Modul 170, einem darin eingesteckten Funktionsmodul 180 und einem kombinierten Funktions-Port-Modul 190 besteht.

Die Basiseinheit weist dabei eine so genannte "Backplane" 112 auf, welche einen PCI-Express-Systembus (PCIe-Bus) 122, einen internen Hochgeschwindigkeits-Netzwerkbus 132 und einen Stromversorgungsbus 142 umfasst. Dabei ist der Stromversorgungsbus 142 mit einem Netzteil 140 verbunden, während der PCI-Express (PCIe)-Bus 122 mit einer Zentraleinheit 120 der Basiseinheit 110 sowie der Hochgeschwindigkeits-Netzwerkbus 132 mit einem zentralen Daten-Weiterleitungs-Funktionsblock 130 ("Switch-Core") verbunden ist. Beispielsweise zum Betrieb oder zur Konfiguration des Switch-Cores 130 ist die Zentraleinheit 120 zudem auch mit dem Switch-Core 130 verbunden.

Die Basiseinheit 110 weist einen ersten Modulschacht 114 auf, in welchem das Portmodul 170 installiert ist. Im Modulschacht 114 ist ein PCIe-Stecker 124, ein Netzwerkstecker 134 sowie ein Stromversorgungsstecker 144 installiert, welcher mit den jeweiligen Bussen der Backplane 112 verbunden sind. Das Portmodul weist einen Netzwerkstecker 176 sowie einen Stromversorgungsstecker 172 im rückwärtigen Bereich zum Einstecken in die entsprechenden Stecker des Modulschachts auf. Weiterhin umfasst das Portmodul 170 eine erste Ethernet-Schnittstelle 178 sowie eine zweite Ethernet-Schnittstelle 179 zum Anschluss von Ethernet-Leitungen. Über die Ethernet-Schnittstelle 178, 179 ankommende Informationen können über die Netzwerk-Bus-Stecker 176 des Moduls und des Modulschachts 134 an den Netzwerkbus 132 sowie an den Switch-Core 130 weitergegeben werden und dann von dort an entsprechende Ports des Switches 100 weitergeleitet.

In einem zweiten Modulschacht 116 der Basiseinheit 110, welcher wiederum einen PCIe-Stecker 126, einen Netzwerkbus-Stecker 136 sowie einen Stromversorgungsstecker 146 aufweist, ist ein Displaymodul 180 als Funktionsmodul 180 installiert. Dieses Displaymodul 180 weist einen PCIe-Stecker 184 sowie einen Stromversorgungsstecker 182 auf, welcher im in Figur 1 dargestellten Aufnahmezustand in die entsprechenden Stecker 126, 146 des zweiten Modulschachts 116 eingesteckt sind. Der weitere, in diesem Modulschacht vorhandene Netzwerkbus-Stecker 136 wird vom Displaymodul 180 nicht benützt. Das Displaymodul 180 weist weiterhin einen Bildschirm 188 zur Darstellung beispielsweise des Zustands einzelner Ports oder Anschluss-Schnittstellen des Switches 100 dar. Die auf dem Display dargestellte Information 188 wird kann weiterhin auch über die PCIe-Stecker 184, 126 und den PCIe-Bus 122 an die Zentraleinheit 120 geschickt werden, welche dann, ggf. nach Einholen weiterer Informationen beispielsweise vom Switch-Core 130, die zusätzliche Informationen auf dem genannten Weg wieder an das Displaymodul 180 zurücksendet.

In einem dritten Modulschacht 118 der Basiseinheit 110 befindet sich ein kombiniertes Port-Funktionsmodul 190, welches beispielsweise als Firewall-Modul 190 ausgebildet sein kann. In Figur 1 ist dieses Modul noch nicht vollständig im Modulschacht 118 aufgenommen, so dass dieses im in Figur 1 dargestellten Zustand noch nicht funktionsfähig im Switch 100 befindlich ist.

Der dritte Modulschacht 118 weist wiederum einen PCIe-Stecker 128, einen Netzwerkbus-Stecker 138 sowie einen Stromversorgungsstecker 148 auf. Das Firewall-Modul 190 weist entsprechend ebenfalls sowohl einen PCIe-Stecker 194, einen Netzwerkbus-Stecker 196 sowie einen Stromversorgungs-Stecker 192 auf, welche im vollständig eingebrachten Zustand des Firewall-Moduls 190 in die entsprechenden Stecker 128, 138, 148 des dritten Modulschachts 118 eingesteckt sind. Weiterhin weist das Firewall-Modul eine Ethernet-Schnittstelle 198 auf, zum Anschluss an einer externen Ethernet-Leitung. Über den PCIe-Bus 122 sowie die PCIe-Stecker 128, 194 des dritten Modulschachts 118 sowie des Firewall-Moduls 190 kann eine auf dem Firewall-Modul 190 enthaltene Firewall-Einheit z.B. durch die Zentraleinheit 120 konfiguriert werden. Auf diese Weise knn beispielsweise ein über ein an der Ethernet-Schnittstelle 198 des Firewall-Moduls 190 angeschlossenes Ethernet-Netzwerk durch diese Firewall abgesichert werden. Die Kommunikation zwischen z.B. dem Switch-Core 130 und dem Ethernet-Port 198 des Firewall-Moduls 190 erfolgt dann intern über die Netzwerk-Bus-Stecker 138, 196 des dritten Modulschachts 118 und des Firewall-Moduls 190 und über den Netzwerkbus 132.

Die Basiseinheit 110 weist weiterhin noch einen fest installierten Ethernet-Port 139 auf, welcher ebenfalls über den Netzwerk-Rückwand-Bus 132 mit dem Switch-Core 130 des Switches 100 verbunden ist.

Das Firewall-Modul 190 kann beispielsweise weiterhin so ausgebildet sein, dass auch an die anderen Ethernet-Ports 178, 179, 139 des Ethernet-Ports angeschlossene Netze über die Firewall-Funktionalität des Firewall-Moduls 190 abgesichert werden können. Dabei kann beispielsweise über die CPU und den Switch-Core eingestellt sein, welche der Ethernet-Anschlüsse 178, 179, 139 dies betrifft und die entsprechende Kommunikation intern über das Firewall-Modul 190 geleitet werden.

Die vorliegende Erfindung betrifft einen modularen Switch für Kommunikations-Netzwerke, insbesondere für industrielle Kommunikations-Netzwerke, wobei die Funktionalität des Switches dadurch erhöht werden kann, dass ein im Switch vorhandenes Port-Modul zum Anschluss von Kommunikationsleitungen gegen ein Funktionsmodul zur Erhöhung der Funktionalität des Switches ausgetauscht werden kann.

## Patentansprüche

1. Modularer Schalt-Netzknoten (100) für ein Kommunikationsnetzwerk,
- wobei der modulare Schalt-Netzknoten (100) eine Schalt-Netzknoten-Basiseinheit (110) und mindestens ein Port-Modul (170, 190) umfasst,
- wobei das mindestens eine Port-Modul (170, 190) mindestens eine Anschluss-Schnittstelle (178, 179, 198) zur Ankopplung an das Kommunikationsnetz aufweist,
- wobei der modulare Schalt-Netzknoten (100) zur Weiterleitung von über eine der Anschluss-Schnittstellen (178, 179, 198) des modularen Schalt-Netzknotens (100) eingehende Kommunikationsdaten an mindestens eine weitere der Anschluss-Schnittstellen (178, 179, 198, 139) des modularen Schalt-Netzknotens (100) ausgebildet und eingerichtet ist,
**dadurch gekennzeichnet,**
- **dass** die Schalt-Netzknoten-Basiseinheit (110) derart ausgebildet und eingerichtet ist, dass mindestens eines der Port-Module (170, 190) gegen ein Funktionsmodul (180, 190) zur Erweiterung der Funktionalität des Schalt-Netzknotens austauschbar ist, wobei die Erweiterung der Funktionalität ein Hinzufugen einer Funktionalität auf OSI-Schicht 4 oder höher ist,
- **dass** die Schalt-Netzknoten-Basiseinheit (110) einen oder mehrere Modul-Aufnahmebereiche (114, 116, 118) aufweist, die sowohl zur Aufnahme von je einem Port-Modul (170, 190) als auch zur Aufnahme von je einem Funktionsmodul (180, 190) vorgesehen und eingerichtet sind,
- **dass** die Schalt-Netzknoten-Basiseinheit (110) einen internen Netzwerkbus (132) zur Weiterleitung von über eine Anschluss-Schnittstelle (178, 179, 198, 139) empfangenen Kommunikationsdaten innerhalb der Schalt-Netzknoten-Basiseinheit (110), und einen Systembus (122) umfasst, wobei der Systembus (122) zur Kommunikation mit einer zentralen Steuereinheit (120) des Schalt-Netzknotens (100) ausgebildet und eingerichtet ist, und
- **dass** die Schalt-Netzknoten-Basiseinheit (110) im Bereich mindestens eines Modul-Aufnahmebereichs (114, 116, 118) eine Netzwerkbus-Schnittstelle (134, 136, 138) zur Kontaktierung eines in dem Modul-Aufnahmebereich (114, 116, 118) befindlichen Port-Moduls (170, 190) und eine Systembus-Schnittstelle (124, 126, 128) zur Kontaktierung eines in dem Modul-Aufnahmebereich (114, 116, 118) befindlichen Funktionsmoduls (180, 190) aufweist.

2. Schalt-Netzknoten nach Anspruch 1,
**dadurch gekennzeichnet, dass** die Schalt-Netzknoten-Basiseinheit (110) zur Erkennung und/oder Konfiguration eines in einem ihrer Modul-Aufnahmebereiche (114, 116, 118) befindlichen Funktionsmoduls (180, 190) ausgebildet und eingerichtet ist, und dass die Schalt-Netzknoten-Basiseinheit (110) zur Konfiguration und/oder Diagnose eines in einem ihrer Modul-Aufnahmebereiche (114, 116, 118) befindlichen Funktionsmoduls (180, 190) über eine Benutzerschnittstelle des Schalt-Netzknotens (100) ausgebildet und eingerichtet ist.

3. Schalt-Netzknoten nach einem der Ansprüche 1 oder 2,
dass das Funktionsmodul (180, 190) eine Modul-Systembus-Schnittstelle (184, 194) zur Kommunikation mit der Systembus-Schnittstelle (124, 126, 128) eines Modul-Aufnahmebereichs (114, 116, 118) der Schalt-Netzknoten-Basiseinheit umfasst.

4. Schalt-Netzknoten nach Anspruch 3,
**dadurch gekennzeichnet, dass** das Funktionsmodul (180, 190) eine Modul-Netzwerkbus-Schnittstelle (196) zur Kommunikation mit der Netzwerkbus-Schnittstelle (134, 136, 138) eines Modul-Aufnahmebereichs (114, 116, 118) der Schalt-Netzknoten-Basiseinheit (110) umfasst.

5. Schalt-Netzknoten nach einem der Ansprüche 2 bis 4,
**dadurch gekennzeichnet, dass** das Funktionsmodul (180, 190) als zusätzliche Recheneinheit zur Unterstützung der zentralen Steuereinheit (120) des Schalt-Netzknotens (100) ausgebildet ist.

6. Schalt-Netzknoten nach einem der Ansprüche 2 bis 5,
**dadurch gekennzeichnet, dass** das Funktionsmodul (180, 190) als ein Server-Modul zur Realisierung einer Serverfunktionalität mit einer selbständigen Zentraleinheit ausgebildet ist.

7. Schalt-Netzknoten nach einem der Ansprüche 2 bis 6,
**dadurch gekennzeichnet, dass** das Funktionsmodul (180, 190) als ein Anzeigemodul und/oder Bedienmodul für den Schalt-Netzknoten (100) ausgebildet ist.

8. Schalt-Netzknoten nach einem der Ansprüche 2 oder 3,
**dadurch gekennzeichnet, dass** das Funktionsmodul (180, 190) als Energiespar-Modul zur Einrichtung und/oder dem Betrieb von Energiespar-Funktionalitäten des Schalt-Netzknotens (100) oder für den Schalt-Netzknoten (100) ausgebildet ist.

9. Schalt-Netzknoten nach einem der Ansprüche 2 oder 3,
**dadurch gekennzeichnet, dass** das Funktionsmodul (180, 190) als Kommunikations-Sicherheitsmodul mit einer Funktionalität zur Einrichtung und/oder Erhöhung von Sicherheits-Funktionen bei der Kommunikation über mindestens eine der Anschluss-Schnittstellen (178, 179, 198, 139) des Schalt-Netzknotens (100) ausgebildet ist.

10. Schalt-Netzknoten nach einem der Ansprüche 2 oder 3,
**dadurch gekennzeichnet, dass** das Funktionsmodul (180, 190) als Echtzeit-Kommunikationsmodul zur Einrichtung oder Erweiterung der Echtzeit-Kommunikation über mindestens eine der Anschluss-Schnittstellen (178, 179, 198, 139) des Schalt-Netzknotens (100) ausgebildet ist.

## Claims

1. Modular switching network node (100) for a communications network,
- wherein the modular switching network node (100) comprises a switching network node base unit (110) and at least one port module (170, 190),
- wherein the at least one port module (170, 190) has at least one connection interface (178, 179, 198) for coupling to the communications network,
- wherein the modular switching network node (100) is adapted and set up for forwarding communication data arriving via one of the connection interfaces (178, 179, 198) of the modular switching network node (100) to at least one more of the connection interfaces (178, 179, 198, 139) of the modular switching network node (100),
**characterised in that**
- the switching network node base unit (110) is adapted and set up in such a way that at least one of the port modules (170, 190) can be swapped for a functional module (180, 190) to expand the functionality of the switching network node, wherein the expansion of the functionality is an addition of a functionality at OSI level 4 or higher,
- the switching network node base unit (110) has one or more module-receiving regions (114, 116, 118), which are provided and set up for both receiving one port module (170, 190) and for receiving one functional module (180, 190) in each instance,
- the switching network node base unit (110) comprises an internal network bus (132) for forwarding communication data received via a connection interface (178, 179, 198, 139) within the switching network node base unit (110), and a system bus (122), wherein the system bus (122) is adapted and set up in particular for communication with a central control unit (120) of the switching network node (100), and
- the switching network node base unit (110) has in the region of at least one module-receiving region (114, 116, 118) a network bus interface (134, 136, 138) for contacting a port module (170, 190) located in the module-receiving region (114, 116, 118) and a system bus interface (124, 126, 128) for contacting a functional module (180, 190) located in the module-receiving region (114, 116, 118).

2. Switching network node according to claim 1,
**characterised in that** the switching network node base unit (110) is adapted and set up for detection and/or configuration of a functional module (180, 190) located in one of its module-receiving regions (114, 116, 118) and that the switching network node base unit (110) is adapted and set up for configuration and/or diagnosis of a functional module (180, 190) located in one of its module-receiving regions (114, 116, 118) via a user interface of the switching network node (100).

3. Switching network node according to claim 1 or 2, that the functional module (180, 190) comprises a module system bus interface (184, 194) for communication with the system bus interface (124, 126, 128) of a module-receiving region (114, 116, 118) of the switching network node base unit.

4. Switching network node according to claim 3,
**characterised in that** the functional module (180, 190) comprises a module network bus interface (196) for communication with the network bus interface (134, 136, 138) of a module-receiving region (114, 116, 118) of the switching network node base unit (110).

5. Switching network node according to one of claims 2 to 4,
**characterised in that** the functional module (180, 190) is constructed as an additional arithmetic logic unit for supporting the central control unit (120) of the switching network node (100).

6. Switching network node according to one of claims 2 to 5,
**characterised in that** the functional module (180, 190) is constructed as a server module for implementing a server functionality with an independent central unit.

7. Switching network node according to one of claims 2 to 6,
**characterised in that** the functional module (180, 190) is constructed as a display module and/or operating module for the switching network node (100).

8. Switching network node according to claim 2 or 3,
**characterised in that** the functional module (180, 190) is constructed as an energy-saving module for setting up and/or operation of energy-saving functionalities of the switching network node (100) or for the switching network node (100).

9. Switching network node according to claim 2 or 3,
**characterised in that** the functional module (180, 190) is constructed as a communication security module with a functionality for setting up and/or increasing security functions during communication via at least one of the connection interfaces (178, 179, 198, 139) of the switching network node (100).

10. Switching network node according to claim 2 or 3,
**characterised in that** the functional module (180, 190) is constructed as a real-time-communication module for setting up or expanding real-time communication via at least one of the connection interfaces (178, 179, 198, 139) of the switching network node (100).

## Revendications

1. Noeud ( 100 ) de réseau de commutation modulaire pour un réseau de communication,
- dans lequel le noeud ( 100 ) de réseau de commutation modulaire comprend une unité ( 110 ) de base de noeud de réseau de commutation et au moins un module ( 170, 190 ) d'accès,
- dans lequel le au moins un module ( 170, 190 ) d'accès a au moins une interface ( 178, 179, 198 ) de connexion pour s'accoupler au réseau de communication,
- dans lequel le noeud ( 100 ) de réseau de commutation modulaire est constitué et agencé pour l'acheminement, à au moins une autre des interfaces ( 178, 179, 198, 139 ) de connexion du noeud ( 100 ) du réseau de commutation modulaire, des données de communication entrant par l'une des interfaces ( 178, 179, 198 ) de connexion du noeud ( 100 ) du réseau de commutation modulaire,
**caractérisé**
- **en ce que** l'unité ( 110 ) de base de noeud de réseau de commutation est constituée et agencée de manière à ce qu'au moins l'un des modules ( 170, 190 ) d'accès puisse être remplacé par un module ( 180, 190 ) fonctionnel d'extension de la fonctionnalité du noeud de réseau de commutation, l'extension de la fonctionnalité étant une addition d'une fonctionnalité sur une couche OSI 4 ou plus haute,
- **en ce que** l'unité ( 110 ) de base du noeud de réseau de commutation a une ou plusieurs parties ( 114, 116, 118 ) de réception de modèle, qui sont prévues et agencées à la fois pour la réception de respectivement un module ( 170, 190 ) d'accès et pour la réception de respectivement un module ( 180, 190 ) fonctionnel,
- **en ce que** l'unité ( 110 ) de base de noeud de réseau de commutation comprend un bus ( 122 ) de système et un bus ( 132 ) interne de réseau pour l'acheminement au sein de l'unité ( 110 ) de base de noeud de réseau de commutation de données de communication reçues par une interface ( 178, 179, 198, 139 ) de connexion, le bus ( 122 ) de système étant constitué et agencé pour la communication avec une unité ( 120 ) de commande centrale du noeud ( 100 ) de réseau de commutation, et
- **en ce que** l'unité ( 110 ) de base de noeud de réseau de commutation a, dans la partie d'au moins une partie ( 114, 116, 118 ) de réception de module, une interface ( 134, 136, 138 ) de bus de réseau pour la mise en contact d'un module ( 170, 190 ) d'accès se trouvant dans la partie ( 114, 116, 118 ) de réception de module et une interface ( 124, 126, 128 ) de bus de système pour la mise en contact d'un module ( 180, 190 ) fonctionnel se trouvant dans la partie ( 114, 116, 118 ) de réception de module.

2. Noeud de réseau de commutation suivant la revendication 1, **caractérisé en ce que** l'unité ( 110 ) de base de noeud de réseau de commutation est constituée et agencée pour la détection et/ou la configuration d'un module ( 180, 190 ) fonctionnel se trouvant dans l'une de ses parties ( 114, 116, 118 ) de réception de module et **en ce que** l'unité ( 110 ) de base de noeud de réseau de commutation est constituée et agencée pour la configuration et/ou pour le diagnostique d'un module ( 180, 190 ) fonctionnel se trouvant dans l'une de ses parties ( 114, 116, 118 ) de réception de module par l'intermédiaire d'une interface utilisateur du noeud ( 100 ) de réseau de commutation.

3. Noeud de réseau de commutation suivant l'une des revendications 1 ou 2,
**caractérisé en ce que** le module ( 180, 190 ) fonctionnel comprend une interface ( 184, 194 ) de bus de système de module pour la communication avec l'interface ( 124, 126, 128 ) de bus de système d'une partie ( 114, 116, 118 ) de réception de module de l'unité de base de noeud ( 100 ) de réseau de commutation.

4. Noeud de réseau de commutation suivant la revendication 3,
**caractérisé en ce que** le module ( 180, 190 ) fonctionnel comprend une interface ( 196 ) de bus de réseau de module pour la communication avec l'interface ( 134, 136, 138 ) de bus de réseau d'une partie ( 114, 116, 118 ) de réception de module de l'unité ( 110 ) de base de noeud de réseau de commutation.

5. Noeud de réseau de commutation suivant l'une des revendications 2 à 4,
**caractérisé en ce que** le module ( 180, 190 ) fonctionnel est constitué sous la forme d'une unité informatique supplémentaire pour assister l'unité ( 120 ) de commande centrale du noeud ( 100 ) du réseau de commutation.

6. Noeud de réseau de commutation suivant l'une des revendications 2 à 5,
**caractérisé en ce que** le module ( 180, 190 ) fonctionnel est constitué en module de serveur pour la réalisation d'une fonctionnalité de serveur ayant une unité centrale autonome.

7. Noeud de réseau de commutation suivant l'une des revendications 2 à 6,
**caractérisé en ce que** le module ( 180, 190 ) fonctionnel est constitué en module d'affichage et/ou en module de service pour le noeud ( 100 ) de réseau de commutation.

8. Noeud de réseau de commutation suivant l'une des revendications 2 ou 3,
**caractérisé en ce que** le module ( 180, 190 ) fonctionnel est constitué en module d'économie d'énergie pour l'établissement et/ou le fonctionnement de fonctionnalités d'économie d'énergie du noeud ( 100 ) de réseau de commutation ou pour le noeud ( 100 ) de réseau de commutation.

9. Noeud de réseau de commutation suivant l'une des revendications 2 ou 3,
**caractérisé en ce que** le module ( 180, 190 ) fonctionnel est constitué en module de sécurisation de communication ayant une fonctionnalité pour l'établissement et/ou l'augmentation de fonctions de sécurisation lors de la communication par au moins l'une des interfaces ( 178, 179, 198, 139 ) de connexion du noeud ( 100 ) de réseau de commutation.

10. Noeud de réseau de commutation suivant l'une des revendications 2 ou 3,
**caractérisé en ce que** le module ( 180, 190 ) fonctionnel est constitué en module de communication en temps réel pour l'établissement ou l'extension de la communication en temps réel par au moins l'une des interfaces ( 178, 179, 198, 139 ) de connexion du noeud ( 100 ) de réseau de commutation.
